# EUROPEAN PATENT APPLICATION

(11) **EP 3 671 748 A1**
(43) Date of publication of application: **24.06.2020**
(21) Application number: 18215698.4
(22) Date of filing: 21.12.2018
(51) Int. Cl.: G11C 7/10, G06N 3/063, G11C 11/54

(54) **IN-MEMORY COMPUTING FOR MACHINE LEARNING**

(71) Applicant: IMEC vzw, 3001 Leuven (BE); Katholieke Universiteit Leuven KU Leuven Research & Development, 3000 Leuven (BE)
(72) Inventor: GUPTA, Mohit, 3001 Leuven (BE); SHAIK, Khaja Ahmad, 3001 Leuven (BE); DEHAENE, Wim, 3001 Leuven (BE)
(74) Representative: DenK iP

(57) **Abstract**

An in-memory processing device for parallelly computing N digital partial sums in a binary neural network during a read cycle comprises at least one ordered sequence of P sub-arrays and of P embedded logic units, with P being an integer number greater than one, each sub-array being associated with a respective one of the embedded logic units. Operations on multiple stored values in the array going beyond bit-wise logic functions can be implemented, in particular reduction operations, including summation, can be obtained by in-memory processing. No dedicated external unit is then needed or such external unit may require less performance. This is particularly interesting for binary neural network applications for which the matrix-vector multiplications conventionally carried out by MAC units can be achieved by multiple in-memory XNOR products, followed by a subsequent in-memory summation.

## Description

### Field of the invention

The present invention relates to the technical field of in-memory computing for machine learning applications, in particular to SRAM-based in-memory computing for binary neural networks.

### Background of the invention

Most hardware currently used for training and running computationally intensive machine learning applications are not very energy-efficient, hampering its widespread use, for instance, in portable low-power edge devices with limited memory capacity and computational power. Deep neural networks (DNNs) have attracted wide attention as they often outperform existing inference and recognition techniques. However, their typical requirements in terms of computational and memory resources are considerable. This makes them unsuitable in use for most embedded systems and battery-powered devices. A frequent accessing of an external memory unit, such as DRAM or SRAM, contributes significantly to the delay and energy cost of a simple interference these DNNs. This is also creating a bottleneck for more performant training hardware.

More resource-friendly solutions have been developed over the past years, for example, a solution which is aiming at the implementation of neural network using sparse, fixed point representations or binary representations for weights in neural networks to reduce the memory requirements. However, the energy cost for repeatedly requesting the binary weights from a DRAM or SRAM memory is still a limiting factor.

Near memory computing and in-memory processing have been proposed to overcome the processor-memory data transfer bottleneck. In Jain et al. "Computing in Memory With Spin-Transfer Torque Magnetic RAM," in IEEE Transactions on Very Large Scale Integration (VLSI) Systems, vol. 26, no. 3, pp. 470-483, March 2018, an in-memory processing approach is described for STT-MRAM memory devices. Multiple wordlines can be enabled simultaneously with the possibility of directly sensing logic functions of values stored in multiple rows of the array within a single access cycle. The magnetic RAM is using magnetic tunnel junctions and encodes bits as different resistance states realized by this junction. However, the resistance sensing during a read cycle is not always reliable for these magnetic RAM devices and error-correction codes are proposed to mitigate this lack of reliability. The amplified sensed currents being representative of the respective bit resistance states, global current references are needed to distinguish between bit-wise logic function results. The proposed solution works for a number of bit-wise logic functions, but does not allow for further in-memory processing capabilities going beyond bit-wise logic functions.

Biswas et al. "Conv-RAM: An energy-efficient SRAM with embedded convolution computation for low-power CNN-based machine learning applications," 2018 IEEE International Solid -State Circuits Conference - (ISSCC), San Francisco, CA, 2018, pp. 488-490, describe an SRAM-embedded convolution architecture. This architecture implements convolution operations by voltage averaging for a set of local arrays. However, the SRAM-embedded convolution architecture requires a digital-to-analog conversion (DAC) of the non-binary inputs signals and a subsequent analog-to-digital conversion (ADC) step of the voltage averaged signals representative of partial results obtained by shortening the memory cell in a same row. The DACs and ADCs are not very area-efficient and require additional power.

Therefore, there is room for improving existing in-memory processing hardware solutions, in particular for machine learning applications.

### Summary of the invention

It is an object of embodiments of the present invention to provide a good in-memory processing device for parallelly computing digital partial sums in binary neural network applications during a read cycle.

Embodiments of the invention can rely on reliable state-of-the-art SRAM technology.

Operations on multiple stored values in the array going beyond bitwise logic functions can be implemented, in particular reduction operations, including summation, can be obtained by in-memory processing. No dedicated external unit is then needed or this unit may require less performance. This is particularly interesting for binary neural network applications for which the matrix-vector multiplications conventionally carried out by MAC units can be achieved by multiple in-memory XNOR products, followed by a subsequent in-memory summation.

The above objective is accomplished by a device according to the present invention.

In a first aspect, the present invention provides an in-memory processing device for parallelly computing N digital partial sums in a binary neural network during a read cycle. The in-memory processing device comprises at least one ordered sequence of P sub-arrays and of P embedded logic units, with P being an integer number greater than one, each sub-array being associated with a respective one of the embedded logic units.

Preferably, this association is also physically expressed, in embodiments of the invention, by providing the embedded logic next to the sub-array with which it is associated, e.g. by providing an ordered sequence S as a sequence with alternating occurrences of sub-arrays and associated embedded logic units. This has the advantage of further minimizing data paths within the in-memory processing device, which are extending between sub-arrays and the associated embedded logic units. However, this physically expressed association is not a limitation for embodiments of the invention and alternative embodiments may provide an ordered sequence S as P consecutive sub-arrays, followed by P consecutive embedded logic units, for example. For such alternative embodiments, the association is a logical one, assigning each of the P embedded logic units to a respective one of the P sub-arrays. The order in the ordered sequence S is also to be understood as a logical ordering, which described the growing partial sums generated by each further sub-array and associated embedded logic unit when stepping through the ordered sequence S, e.g. stepping from one sub-array and its associated embedded logic unit to the next one sub-array and its associated embedded logic unit.

In accordance with the present invention, each sub-array comprises:
▪ a plurality of memory cells arranged in rows and N columns, wherein
   each column of one of the sub-arrays corresponds to a column of every other sub-array, thus defining a partition of a global array into the sub-arrays of each ordered sequence, and individual rows of memory cells are concurrently addressable by one of a plurality of binary activation signals, and
   each memory cell is adapted for storing a binary weight variable and is comprising a multiplier circuit adapted for changing, according to a cell read bit or the complement thereof, a pre-charge state of each read bitline coupled to the memory cell, said cell read bit representing a binary product of the stored weight variable and an applied activation signal (and also the
   inverted multiplied output),
▪ a plurality of activation bitlines, each being coupled to the memory cells of a same row, for receiving the plurality of binary activation signal,
▪ a plurality of paired first and a second high-impedance read bitlines, each paired first and second read bitline being coupled to the memory cells of a same column.

Furthermore, each embedded logic unit comprises:
▪ detection means connected to the read bitlines of the associated sub-array for detecting a charge state for each connected read bitline, ▪ a combinational logic for generating N partial digital sums during the read cycle, based on the detected charge states for the associated sub-array and on the N partial digital sums generated for a combinational logic preceding the combinational logic in the same ordered sequence,
   wherein
   each of the N partial digital sums generated by a combinational logic is accumulated from cell read bits with respect to concurrently addressed memory cells in a same column of the associated sub-array and from cell read bits with respect to further concurrently addressed memory cells in the corresponding columns of all sub-arrays preceding the associated sub-array in the same ordered sequence, there being two cell read bits with respect to two concurrently addressed memory cells in each column of the sub-array being first in each ordered sequence.

According to some embodiments of the invention, the detection means for each embedded logic unit may be comprised by the combinational logic of the embedded logic unit, e.g. first stage of the combinational logic (e.g. first stage provided as an inverter) are also configured for detecting charge states of the connected read bitlines. In other embodiments, the detection means for each embedded logic unit may be provided as distinct circuitry (e.g. dedicated sense amplifiers) the outputs of which are coupled to the inputs of the combinational logic.

In embodiments of the present invention, the embedded logic unit being first in each ordered sequence may further comprise N relay circuits, each relay circuit being operatively connectable to the corresponding paired first and second read bitline of the next sub-array in that ordered sequence, and adapted for changing a pre-charge state for each of the operatively coupled read bitlines of the next sub-array in that ordered sequence, according to a relay read bit and the complement thereof, each relay read bit corresponding to a least significant bit of one of the N partial digital sums generated by the combinational logic of the embedded logic unit.

In an in-memory processing device according to embodiments of the present invention, each of the N digital partial sums computed during one read cycle may comprise for instance, but not limited thereto, at least nine binary products.

An in-memory processing device according to embodiments of the present invention may further comprise a plurality of data bitlines connecting each embedded logic unit of the at least one ordered sequence to the next embedded logic unit of that ordered sequence, the plurality of data bitlines being configured for transmitting at least a most significant bit for each of the generated N digital partial sums. In embodiments, P may be an integer number greater than two for the at least one ordered sequence and the plurality of data bitlines may be configured for transmitting all significant bits for each of the N digital partial sums generated by the combinational logic of the second and of any further embedded logic unit in the at least one ordered sequence (S).

In an in-memory processing device according to embodiments of the present invention, detectable charge states for paired first and second read bitlines may respectively be indicative of a first Boolean function and a second Boolean function, both first and second Boolean function having one read bit in a column of the associated sub-array as argument or both first and second Boolean functions having two read bits in a same column of the associated sub-array as arguments. In particular embodiments, for at least two consecutive embedded logic units of the at least one ordered sequence, both first and second Boolean functions may be having two read bits in a same column of the associated sub-array as arguments, and the dual of said first Boolean function may be equating to the complement of said second Boolean function.

In an in-memory processing device according to embodiments of the present invention, the combinational logic for each embedded logic unit may comprise dynamic OR gates, dynamic NAND gates, or a combination of dynamic OR gates and dynamic NAND gates, individual dynamic gates being arranged for receiving detected charge states for a paired first and second read bitline as input signals.

In an in-memory processing device according to embodiments of the present invention, the multiplier circuit of a memory cell may comprise a dynamic XNOR gate and a dynamic XOR gate.

An in-memory processing device according to embodiments of the present invention may comprise a plurality of ordered sequences of P_{K} sub-arrays and of P_{K} embedded logic units each, each P_{K} being an integer number greater than one, and at least one dynamic adder for generating N digital partial sums by further accumulating the partial digital sums generated by the combinational logics of the embedded logic units being last in each individual ordered sequence.

In an in-memory processing device according to embodiments of the present invention, the embedded logic units may also be adapted for generating the complement of said generated N digital partial sums. The complement of said generated N digital partial sums may be generated in such a way that a representative signal level thereof corresponds to a logical zero during a pre-charging phase of the read bitlines.

In an in-memory processing device according to embodiments of the present invention, the memory cells of at least one sub-array may be provided as SRAM cells, each comprising fourteen transistors, and at least one pair of two stacked SRAM cells may be provided for each column such that a first one of the two stacked SRAM cells of the at least one pair is directly connected to the read bitlines of that column and the second one of the two stacked SRAM cells of the at least one pair is coupled to the read bitlines of that column only via the first of the two stacked SRAM cells of the at least one pair.

In a second aspect, the present invention provides a hardware system for computing N digital partial sums in parallel in a binary neural network. The hardware system comprises an in-memory processing device according to any of the embodiments of the first aspect of the present invention, and a row decoder configured for simultaneously applying multiple binary activation signals to multiple activation bitlines of concurrently addressed rows at the start of a read cycle.

In accordance with embodiments of the present invention, the hardware system may further comprise a multi-bit adder connected to the in-memory processing device, the multi-bit adder being adapted for further accumulating, over a plurality of read cycles, the N digital partial sums obtained by the in-memory processing device for each read cycle in the plurality of read cycles.

It is an advantage of embodiments of the invention to limit data paths lengths with respect to data stored in the memory device by incorporating processing logic directly into the arrayed memory structure of the device. Therefore, read data is already (pre-) processed inside the memory device, which advantageously lowers the data traffic and the out-of-memory processing time.

It is an advantage of embodiments of the invention that data bits/weights can be stored and read in an energy-efficient manner.

It is an advantage of embodiments of the invention that fully accumulated sums comprising a plurality of binary products can be obtained in fewer read cycles, which is increasing the throughput and lowering the latency in binary neural networks using the in-memory processing device. It is an advantage of embodiments of the invention that N partial sums are computed in parallel.

It is an advantage of embodiments of the invention that bitwise Boolean operations can be performed on the read bitlines of the in-memory processing device.

It is an advantage of embodiments of the invention that multiple rows of the in-memory device can be simultaneously addressed by multiple activation signals for obtaining multiple cell read bits in individual columns of the global array of memory cells.

It is an advantage of embodiments of the invention that non-volatile memory cells can be implemented for storing the weights W over longer periods of time without the need of regularly refreshing or reading in (e.g. at power start-up) the stored weights, which further reduces the energy cost for binary neural networks using such in-memory processing devices.

Particular and preferred aspects of the invention are set out in the accompanying independent and dependent claims. Features from the dependent claims may be combined with features of the independent claims and with features of other dependent claims as appropriate and not merely as explicitly set out in the claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, in which:
FIG. 1 shows an in-memory processing device in accordance with an embodiment of the invention.
FIG 2 shows an exemplary multiplying static random access memory cell including twelve transistors, which can be used in embodiments of the present invention.
FIG. 3 shows a memory cell according to an alternative embodiment of the invention, which includes eight transistors.
FIG 4 illustrates how controlled transistors may be arranged in some embodiments of the invention to form a multiplier circuit for a memory cell.
FIG. 5 illustrates a prior art memory mapping scheme for assigning weight variables of a layer-to-layer mapping in neural networks to different memory cells of a memory array.
FIG. 6 is illustrating a memory mapping scheme for assigning weight variables of a layer-to-layer mapping in neural networks to different memory cells of a global array comprising a plurality of sub-arrays, in accordance with an embodiment of the invention.
FIG. 7 illustrates how two binary products related to two concurrently addressed memory cells of a same column in the first sub-array of an in-memory processing device may be accumulated into a partial sum within the associated first embedded logic unit, in accordance with an embodiment of the invention.
FIG. 8 shows an in-memory processing device according to an embodiment of the invention, comprises an ordered sequence of eight sub-arrays and eight associated embedded logic units.
FIG. 9 illustrates a way of generating the significant bits and their complements inside a combinational logic of an embedded logic unit, according to an embodiment of the invention.
FIG. 10 shows an example of a relay circuit for a single column slice, which can be used in embodiments of the present invention.
FIG. 11 shows in-processing memory device according to an embodiment of the invention, which is capable of accumulating up to and including nine binary products into a digital partial sum for each of the N columns of the global array during a single read cycle, comprising a plurality of ordered sequences of sub-arrays and associated embedded logic units.
FIG. 12 shows two stacked exemplary multiplying static random access memory cells, each including fourteen transistors, which can be used in embodiments of the present invention.
FIG. 13 shows an exemplary multiplying non-volatile memory cell which can be used in embodiments of the present invention.

The drawings are only schematic and are non-limiting. In the drawings, the size of some of the elements may be exaggerated and not drawn on scale for illustrative purposes. The dimensions and the relative dimensions do not necessarily correspond to actual reductions to practice of the invention.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art.

It should be noted that the use of particular terminology when describing certain features or aspects of the invention should not be taken to imply that the terminology is being re-defined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

### DEFINITIONS

In-memory processing, in the context of the present invention, refers to a memory structure, such as an array or a plurality of sub-arrays comprising memory cells, which also comprises processing logic or processing functionality on stored data bits. In contrast to near memory computing or conventional memory structures which are not in-memory processing, the requested data is not only read and communicated to an external processing unit, but is already modified or processed as of the moment it is sent out of the memory structure. In exemplary embodiments processing of requested data bits, before communicating the results to peripheral further processing units, may include bitwise Boolean operations such as, but not limited to XOR and/or XNOR multiplication of pairs of requested data bits or addition of one or more requested data bits or intermediate functional results thereof. In-memory processing is highly desirable for fast and energy-efficient computing hardware as it is mitigating the von Neumann bottleneck. Having a processing unit waiting for unprocessed fetched data from memory before it can start processing it is often an inefficient use of the available resources and bandwidth. Therefore, a limiting the amount of raw data communicated to the processing unit and sending (pre-) processed data to the processing unit instead, is providing a more efficient use of the available resources and bandwidth. Whereas near memory computing tries to limit the length of data paths from the memory structure to a nearby processing logic, in-memory processing goes one step further by incorporating the processing logic directly into the memory structure.

Dynamic gates and dynamic adders, described in embodiments of the invention, refer to combinational logic circuits which implement logic gates or adders (e.g. full adders, half adders) dynamically in response to a change in a pre-charge signal (e.g. provided by a local or global clock signal). In embodiments of the invention, a pre-charge signal may change from a high state to a low state, whereby the dynamic gate or dynamic adder is toggled from a pre-charge phase into an evaluation phase during which an output capacitance is changed (e.g. charged or discharged) in function of the input arguments applied. The toggling is typically obtained by switching a control switch receiving the pre-charge/clock signal into a conducting state. Dynamic gates and/or adders are advantageous in terms of speed and area efficiency. The pre-charging signal for read bitlines of the in-memory processing devices may be also used for the dynamic gates and/or dynamic adders, whereby synchronous operation between both is ensured.

In the context of binary neural networks, typically one of the two values {-1, 1} is assigned to a binary-valued neural network weight. It is understood that, also in the context of the present invention, these two values can be encoded in binary logic as {0, 1}. The same encoding can be used for data inputs that have been binarized. There exists a group homomorphism between the group for the set {-1, 1} equipped with the multiplication operation and the group for the encoded set {0, 1} equipped with the bit-wise XNOR operation.

In a first aspect the invention relates to an in-memory processing device which is capable of computing N digital partial sums in parallel during a single read (access) cycle, for instance, in binary neural network applications.

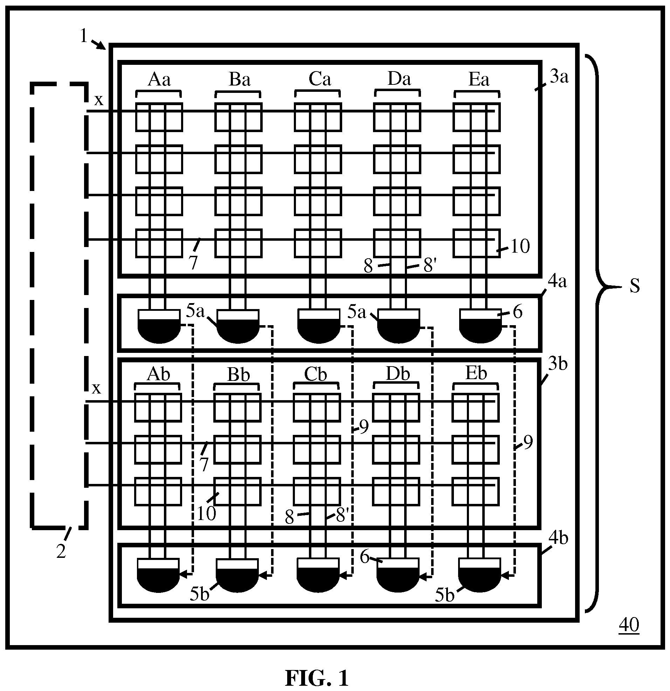

An exemplary in-processing device is shown schematically in FIG. 1. The in-memory processing device 1 comprises at least one ordered sequence S of P sub-arrays and P embedded logic units, wherein with P is an integer number greater than one. For the embodiment referred to in FIG. 1, there is one ordered sequence S of two sub-arrays 3a, 3b and two embedded logic units 4a, 4b. Each sub-array of the ordered sequence S is associated with an embedded logic unit of that ordered sequence S. For instance, the first sub-array 3a is associated with the first embedded logic unit 4a and the second sub-array 3b is associated with the second embedded logic unit 4b. Preferably, with such an ordered sequence S, the sub-arrays are arranged in an alternation with the embedded logic units, e.g. between a sub-array and the next sub-array in the ordered sequence S the embedded logic unit associated with the former is provided. Each sub-array 3a, 3b in the at least one ordered sequence S comprises a plurality of memory cells 10 which are arranged in rows and N columns, e.g. N = 5 columns A-E in FIG. 1. Typically, each column is logically related to one of the N digital partial sums to be computed. The individual sub-arrays 3a, 3b may have an equal number of rows or may have different number of rows each, e.g. the first sub-array 3a of the in-memory processing device 1 comprises three rows of memory cells 10, whereas the second sub-array 3b comprises three rows of memory cells 10. As explained later, according to preferred embodiments of the invention, the first sub-array of each ordered sequence comprises 2L rows (L being an integer number) and each further sub-array of that same ordered sequence comprises L rows each. Each column of a sub-array is (logically) corresponding to a column for each other sub-array, including the sub-arrays of a the same or a different ordered sequence. This correspondence is on a logical level; there is no direct physical connection between corresponding columns of different sub-arrays. Referring to FIG.1, for example, each one of the five columns Aa-Ea of the first sub-array 3a is corresponding to one of the five columns Ab-Eb of the second sub-array 3b (being the only other sub-array in this case). Here, the correspondence is such that corresponding columns are designated by the same capital letter, e.g. A-A, B-B, and so forth. Preferably, the individual sub-arrays of the one or more ordered sequences are horizontally or column-aligned within the in-memory processing device, whereby the column correspondence is very much facilitated. This correspondence between columns of the individual sub-arrays of the in-memory processing device, in combination with the same column count for each sub-array, is sufficient for defining a partition or division of a global array into the individual sub-arrays. For instance, a global array for the in-memory processing device 1 shown in FIG. 1 is defined by the larger (e.g. composite) array structure comprising the two sub-arrays 3a, 3b. A final output for the in-memory processing device typically is computed over the so defined global array, meaning that the N digital partial sums are computed over all the sub-arrays. For a large enough global array, e.g. a global array comprising a large number of sub-arrays (e.g. hundreds or thousands of sub-arrays, depending on the application), the N digital partial sums that are computed by the in-memory processing device may constitute N digital complete sums which do not need any further accumulation. Individual rows of memory cells 10 are concurrently addressable (e.g. enabled) by a plurality of binary activation signals x, wherein the plurality of binary activation signals x are applicable to a plurality of activation bitlines 7 also included in the in-memory processing device 1. Each of the plurality of activation bitlines 7 is coupled to the memory cells 10 of a same row. As a result, a binary activation signal x received by an activation bitline for a particular row is applied to each memory cell 10 comprised in that particular row. The in-memory processing device 1 further comprises a plurality of paired first and a second high-impedance read bitlines 8, 8'. Each of the plurality of paired first and second read bitlines 8, 8' is coupled to the memory cells 10 of a same column, meaning that the first read bitline 8 of the bitline pair is coupled to the memory cells 10 of a same column and the second read bitline 8' of the bitline pair is also coupled to the memory cells 10 of that same column. It is noted that each individual sub-array 3a, 3b is provided with its own collection of paired first and second read bitlines 8, 8', because there is no direct physical point-to-point connection between the read bitlines for a column of one sub-array and the read bitlines for the corresponding columns for each other sub-array. The in-memory processing device 1 may further include pre-charging circuitry for pre-charging each read bitline of the plurality of paired first and a second high-impedance read bitlines 8, 8' to a predetermined pre-charge state at the beginning of a read cycle, e.g. high-impedance read bitlines which are pre-charged to a pre-charge state corresponding to a VDD or VSS voltage level.

In embodiments of the invention, each memory cell 10 is adapted for storing a binary weight variable w and also comprises a multiplier circuit. The multiplier circuit of each memory cell 10 is adapted for changing a pre-charge state for each read bitline 8, 8' that is coupled to that memory cell 10 according to a cell read bit R or the complement thereof Rb. The cell read bit is representing a binary product of the stored weight variable w and an applicable activation signal x, e.g. a binary product as defined by a two-bit XNOR operation: *w* ⊕ *x* (operator notation for w XNOR x). According to some embodiments of the invention, each memory cell 10 (e.g. an SRAM cell), when storing the binary weight variable w, is also storing the complement thereof wb.

Each embedded logic unit comprises detection means which are connected to the read bitlines of the associated sub-array. For the embodiment in FIG. 1, for example, both the first embedded logic unit 4a and the second embedded logic 4b are comprising detection means 6 connected to the read bitlines 8, 8' of the associated first sub-array 3a and the associated second sub-array 3b, respectively. A charge state for each connected read bitline is detected by the detection means 6, which may comprise a bank of inverting or amplifying voltage buffers, charge amplifiers, etc. According to a preferred embodiment, the charge state for each connected read bitline may be detected by an inverter, which is providing a full swing at its output. This is particularly useful for a reliable functioning of the subsequently connected combinational logic, which then may comprise the more energy-efficient dynamic NAND and dynamic OR gates rather than dynamic AND and dynamic NOR gates, which may be used with a non-inverting detection means but which are having three times more frequent output switching transitions. In other embodiments of the invention, the charge state for each connected read bitline may be detected by sense amplfiers for converting a small-swing input to a full swing output. Small-swing charge state detection may be favorable for reducing the energy consumption of the in-memory processing device. The detected charge states for the read bitlines of the associated sub-array are provide a set of input signals applicable to a combinational logic. Each embedded logic unit 4a, 4b comprises a separate combinational logic 5a, 5b for generating N partial digital sums related to the respective associated sub-array 3a, 3b during a single read cycle. In addition to the detected charge states for the read bitlines of the associated sub-array, each combinational logic is also receiving input signals which form part of the N partial digital sums that are generated during the same read cycle by a combinational logic preceding the current combinational logic in the same ordered sequence S. For the present example in FIG. 1, the first sub-array 3a is preceding the second sub-array 3b in the ordered sequence S. This means that the first combinational logic 5a is receiving the detected charge states for the paired first and second read bitlines 8, 8' of the associated first sub-array 3a as input signals, whereas the second combinational logic 5b is receiving as input signals the detected charge states for the paired first and second read bitlines 8, 8' of the associated second sub-array 3b and at least a portion of the N digital partial sums generated by the first combinational logic 5a associated with the first sub-array 3a. Here, a portion of the N digital partial sums generated by a preceding combinational logic may refer to the generated N digital partial sums as a whole (e.g. all significant bits of each of the N digital partial sums necessary to represent the partial sum as binary string) or may refer to only some of the bits composing each of the generated N digital partial sums, e.g. only the most significant bits thereof. In FIG. 1, the portion of the N digital partial sums generated within the embedded logic unit associated with a preceding sub-array is transmitted over a plurality of data bitlines 9 connecting the first combinational logic 5a of the first embedded logic unit 4a to the second combinational logic 5b of the second embedded logic unit 4b. In embodiments of the invention, each of the N partial digital sums generated by a combinational logic for the associated sub-array, is accumulated from cell read bits R with respect to concurrently addressed memory cells in a same column of the associated sub-array and from cell read bits R with respect to concurrently addressed memory cells in the corresponding columns of all sub-arrays preceding the associated sub-array in the same ordered sequence. In the present example shown in FIG. 1, this means that each digital partial sum of the N partial digital sums generated by the first combinational logic 5a for the associated first sub-array 3a, is accumulated from cell read bits R with respect to concurrently addressed memory cells 10 in a same column (e.g. one of the five columns Aa to Ea) of the first sub-array 3a. Also, each digital partial sum of the N partial digital sums generated by the second combinational logic 5b for the associated second sub-array 3b, is accumulated from cell read bits R with respect to concurrently addressed memory cells 10 in a same column (e.g. one of the five columns Ab to Eb) of the second sub-array 3b and from cell read bits R with respect to concurrently addressed memory cells 10 in the corresponding columns of the first sub-array 3a (e.g. the five corresponding columns Aa to Ea) preceding the second sub-array 3b in the same ordered sequence S. In other words, digital partial sums which are generated previously by a combinational logic associated with a preceding sub-array of an ordered sequence, are taken into account by the subsequent sub-arrays and associated embedded logic units of that same ordered sequence, e.g. the subsequent sub-arrays and associated embedded logic units of that same ordered sequence are further accumulating the already obtained digital partial sums so as to generate more comprehensive N partial digital sums, e.g. N digital partial sums which each comprise a larger number of read bits/binary products. Or, put in yet other words, partial results (e.g. the digital partial sums) are rippling through the sequence of sub-arrays, each embedded logic associated with one of the sub-arrays contributing to the formation of a more complete result, wherein the last embedded logic unit in an ordered sequence is obtaining the most complete result (e.g. the most completed N digital partial sums for a particular ordered sequence). It is noted that this further accumulation or rippling through of partial results by subsequent sub-arrays and associated embedded logic units in an ordered sequence is achieved within a single read access cycle. Moreover, further subsequent sub-arrays and associated embedded logic units in an ordered sequence are only contributing to the accumulation or rippling through of partial results insofar as at least one of their respective rows has been addressed during the read cycle.

According to embodiments of the invention, there are two cell read bits with respect to two concurrently addressed memory cells in each column of the sub-array that is first in each ordered sequence. In the present example shown in FIG. 1, this means that there are two cell read bits R1, R2 with respect to two concurrently addressed memory cells 10 in each column (e.g. columns Aa-Ea) of the first sub-array 3a in the ordered sequence S.

The in-memory processing device may form part of a larger hardware system 40, which is also including a modified row decoder 2. The modified row decoder 2 is configured for addressing multiple rows of memory cells 10 concurrently during a single read (access) cycle. For instance, the modified row decoder 2 is configured for addressing simultaneously at least one row in each sub-array, e.g. the first row of memory cells in each sub-array in a first read cycle, the second row of memory cells in each sub-array in a second read cycle, etc. Moreover, the modified row decoder 2 may address two rows of a same sub-array at the same time, e.g. addressing simultaneously the first row of memory cells in each sub-array and a further row of memory cells in each sub-array that is the first one in an ordered sequence S. During a write cycle, such modified row decoder 2 typically behaves like a conventional (unmodified) row decoder used for writing values to individual rows, one row at a time. A modified row decoder 2, when operating, is also applying the plurality of binary activation signals x to the plurality of concurrently addressed rows.

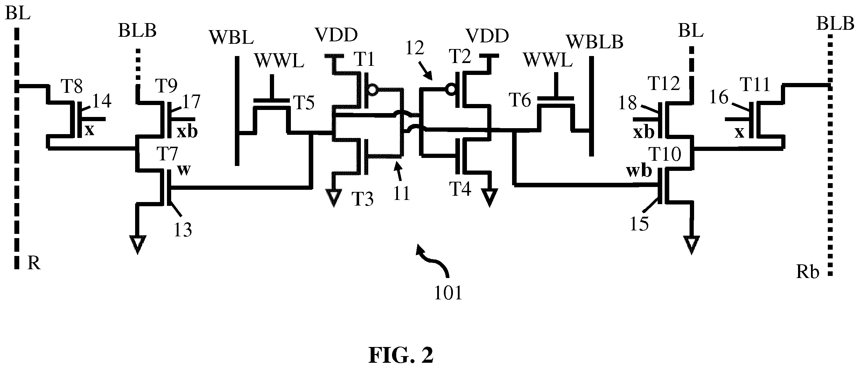

FIG 2 shows an exemplary multiplying static random access memory cell 101, short "mSRAM" memory cell 101, which can be used in embodiments of the present invention. The memory cell 101 comprises twelve transistors, four of which (e.g. T1-T4) form two cross-coupled inverters 11, 12 for retaining a binary weight variable w which is stored in the "mSRAM" memory cell 101. Hence, no periodic refreshment of the stored variable is necessary, which gives an advantage over a less energy-efficient DRAM cell design requiring a regular refreshment for not losing the stored variable. Transistors T5 and T6 enable writing of the binary weight variable w to be stored in the memory cell 101 and their gates are typically connected to a write wordline WWL. In addition, each transistor T5 and T6 has one of its inputs coupled to a write bitline, e.g. an input of T5 is coupled to the write bitline WBL and an input of T6 is coupled to the inverted write bitline WBLB, wherein write bitlines are configured to apply a "High" voltage signal or a "Low" voltage signal to an input of the transistor T5 or T6. These voltage signals represent a binary value of the weight variable w to be stored, e.g. one or zero. The write wordline and the two write bitlines which are coupled to each memory cell 101 located at their intersection, may be provided as additional signal lines in each sub-array. During writing, the two write bitlines WBL and WBLB are configured to provide voltage signals that are complementary/inverted in respect of each other, e.g. WBL provides a "High" signal and WBLB provides a "Low" signal, or vice versa. If the write wordline WWL is brought to "High" state, the two transistors T5 and T6 switch on. The complementary voltage signals applied to their respective inputs, being representative of the binary weight variable w to be stored and its complement wb, may then be transferred to the two cross-coupled inverters 11, 12 for retaining the applied binary weight variable w permanently for as long as the memory cell is powered by an external power source. A first control signal of the memory cell 101 is corresponding to the stored binary weight variable w and is applied to a first control terminal 13 of a first dynamic AND gate being composed of the two serially coupled transistors T7 and T8 of the memory cell 101. A second control signal of the memory cell 101 is corresponding to the complement of the stored binary weight variable wb and is applied to a first control terminal 15 of a second dynamic AND gate being composed of the two serially coupled transistors T10 and T11 of the memory cell 101. A binary activation signal x, and optionally its complement xb, are provided at the memory cell 101, e.g. as signals carried on activation bitlines. Alternatively, the complement xb of the binary activation signal x may be generated by the memory cell 101 itself. The binary activation signal x is applicable as third and fourth control signals to a second control terminal 14 of the first dynamic AND gate and a second control terminal 16 of the second dynamic AND gate, respectively. The memory cell 101 also comprises a third dynamic AND gate composed of the two serially coupled transistors T7 and T9 of the memory cell 101 and a fourth dynamic AND gate composed of the two serially coupled transistors T10 and T12 of the memory cell 101. In consequence, transistor T7 is shared by the first and third dynamic AND gate. Likewise, transistor T10 is shared by the second and fourth dynamic AND gate. Furthermore, the complement of the third and fourth binary control signals, xb, is also applicable to a second control terminal 17 of the third dynamic AND gate and a second control terminal 18 of the fourth dynamic AND gate, respectively.

The first AND gate if open, e.g. if both transistors T7 and T8 are switched on, operatively couples a first read bitline BL of a pair of high-impedance read bitlines to a reference potential, e.g. digital ground GND, such that a current may flow from the first read bitline BL through the two serially coupled transistors T7, T8 towards the reference potential. In contrast, if the first AND gate is closed, e.g. if one or both transistors T7 or T8 are switched off, the first read bitline BL is operatively decoupled from the reference potential, e.g. digital ground GND, such that no current flows from the first read bitline BL towards the reference potential via the two serially coupled transistors T7, T8. The second AND gate if open, e.g. if both transistors T10 and T11 are switched on, operatively couples a second read bitline BLB of a pair of high-impedance read bitlines to the reference potential, e.g. digital ground GND, such that a current may flow from the second read bitline BLB through the two serially coupled transistors T10, T11 towards the reference potential. In contrast, if the second AND gate is closed, e.g. if one or both transistors T10 or T11 are switched off, the second read bit line BLB is operatively decoupled from the reference potential, e.g. digital ground GND, such that no current flows from the second read bitline BLB towards the reference potential via the two serially coupled transistors T10, T11. Similarly, the third AND gate if open, e.g. if both transistors T7 and T9 are switched on, operatively couples the second read bitline BLB to the reference potential, e.g. digital ground GND, such that a current may flow from the second read bitline BLB through the two serially coupled transistors T7, T9 towards the reference potential, whereas no such current flows through the two serially coupled transistors T7, T9 if the third AND gate is closed, e.g. if one or both transistors T7 or T9 are switched off, effectively decoupling the second read bitline BLB from the reference potential, e.g. digital ground GND. Eventually, the fourth AND gate if open, e.g. if both transistors T10 and T12 are switched on, operatively couples the first readbit line BL to the reference potential, e.g. digital ground GND, such that a current may flow from the first read bitline BL through the two serially coupled transistors T10, T12 towards the reference potential, whereas no such current flows through the two serially coupled transistors T10, T12 if the fourth AND gate is closed, e.g. if one or both transistors T10 or T12 are switched off, effectively decoupling the first read bitline BL from the reference potential, e.g. digital ground GND. The foregoing description implies that the first and second read bitlines are pre-charged to a predetermined charge state, e.g. a predetermined charge state corresponding to a positive supply voltage VDD. However, embodiments are not limited to this particular predetermined charge state. For instance, the predetermined charge state may be corresponding to a negative supply voltage VSS and the flow of currents through the resistors is reversed. For both the binary activation signal x and its complement xb are logical "0" is typically asserted during the write cycles.

Based on the foregoing details, it appears that the first read bitline BL is operatively decoupled from the reference potential, e.g. digital ground, if and only if the first and the fourth AND gate are closed. This situation is referred to as a charge state corresponding to a logical "1". A situation in which the first read bitline BL is operatively coupled to the reference potential accordingly is described by a logical "0". As the corresponding transistors of the first and the fourth AND gate are controlled by the four binary control signals w, x, wb and xb, only two of which are independent (e.g. w and x), the condition for a decoupled first read bitline BL translates into: BL = NOT(w*x + wb*xb) = XOR(w, x), meaning the first read bitline BL is operatively decoupled from the reference potential if XOR(w, x) equates to a logical "1". Here, it is assumed that the symbols for control signals w, x, wb, xb are associated with a Boolean type for binary logic, e.g. true or false, or "0" or "1". This association then defines the two complementary relations NOT(x) = xb and NOT(w) = wb. The binary logic operators "*" and "+" are used to represent a "logical AND" and a "logical OR", respectively. In analogy, the second read bitline BLB is operatively decoupled from the reference potential, e.g. digital ground, if and only if the second and the third AND gate are closed. As the corresponding transistors of the second and the third AND gate are controlled by the four control signals w, x, wb and xb, only two of which are independent (e.g. w and x), this condition for a decoupled second read bitline BLB translates into: BLB = NOT(w*xb + wb*x) = XNOR(w, x), meaning the first read bitline BL is operatively decoupled from the reference potential if XNOR(w, x) equates to a logical "1". As can be noticed, the two paired read bitlines BL and BLB are themselves related each other via the a complementary relation BLB = NOT (BL). Considering the case of a single memory cell 101 in a same column of a sub-array being addressed, the assigned logical state of the second read bitline BLB is coinciding with the cell read bit R according to which the multiplier circuit of the memory cell 101 is changing the pre-charged state of the second read bitline BLB to which it is coupled, e.g. R = BLB. Likewise, one has Rb = BL for the memory cell 101 studied in isolation. As explained hereinbelow, this may not be true any longer if more than a single memory cell 101 in a same column of a sub-array is concurrently addressed by activation signals x during a single read cycle.

The initial first and second charges which respectively define the predetermined pre-charge states for the pair of high-impedance read bitlines BL and BLB and which are stored on the pair of high-impedance read bitlines for the purpose of reading out a value for the cell read bit R of at least one connected memory cell 101, may be provided by a suitable pre-charge circuitry (not shown) during a pre-charging step prior to the read access. Such pre-charge circuitry is typically arranged for operatively connecting a power supply source to the plurality of pairs of first and second read bitlines, e.g. via a pre-charge control switch. If, for example, pre-charge circuitry is operatively connecting a positive power supply source VDD to the plurality of pairs of first and second read bitlines, then the initial charges will reflect a "High" voltage state, e.g. a logical "1", as the predetermined pre-charge state. The pre-charge circuitry is disconnecting the power supply source from the plurality of read bitlines at the end of the pre-charging cycle and the supplied initial charges will remain stored on the high-impedance read bitlines only if these read bitlines are effectively decoupled from the (more negative) reference potential, e.g. digital ground. Thus, only if the corresponding above conditions BL = XOR(w,x) or BLB = XNOR(w,x) are true. Because of their respective complementary behavior, only one of the read bit lines is discharged (or charged if the predetermined pre-charge state is corresponding to a logical "0", e.g. by pre-charging with a power supply source at a negative supply voltage VSS) by currents flowing through one of the AND gates towards the reference potential, e.g. digital ground. Reading out a value for the cell read bit R for the addressed memory cell 101 on one read bitline is thus accompanied by reading out a value for the complement of the cell read bit Rb = NOT (R) on the other read bit line. The discharging/charging of a read bitline, e.g. the first or second read bitlines BL or BLB, may be detected as a voltage drops or integrated charge currents by a detection means of the associated sub-array to which the read bitline is connected.

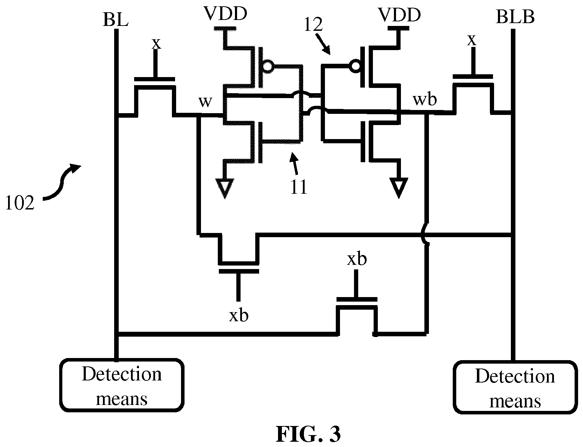

FIG. 3 shows a memory cell according to an alternative embodiment of the invention. This memory cell 102 comprises a reduced number of transistors, e.g. eight transistors, which is advantageously decreasing the required design area per memory cell, which leads to denser in-memory processing devices. However, the memory cell 102 is not provided with separate write bitlines for writing the binary weight variable w to be stored in the memory cell 102 during a write cycle. This writing is, in this example, achieved via the read bitlines too. This is in contrast to the embodiment relating to FIG. 2, in which the memory cell has decoupled bitlines for reading access and writing access, which improves noise margins. For the memory cell 102 in FIG. 3, the first read bitline BL of a pair of first and second high-impedance read bitlines BL, BLB (also write bitlines) coupled to the memory cell 102 is discharged (e.g. by effectively coupling it to a more negative reference potential, e.g. digital ground) with respect to a predetermined pre-charge state corresponding to a "High" voltage state, e.g. a logical "1", if the binary activation signal x and the stored binary weight variable w fulfill the condition "XOR (x, w) is true". This is equivalent to stating that the complement of the cell read bit Rb associated with the memory cell 102 equates to a logical "1". The second read bitline BLB of a pair of first and second high-impedance read bitlines is discharged (e.g. by effectively coupling it to a more negative reference potential, e.g. digital ground) with respect to a predetermined pre-charge state corresponding to a "High" voltage state, e.g. a logical "1", if the binary activation signal x and the stored binary weight variable w fulfill the condition "XNOR (x, w) is true". This is equivalent to stating that the cell read bit R associated with the memory cell 102 equates to a logical "1". Again, if multiple rows of the same sub-array are simultaneously addressed by activation signals x, the read bitlines BL and BLB may be discharged (or charged) by only one or several of the simultaneously addressed memory cells in the same column of the sub-array.

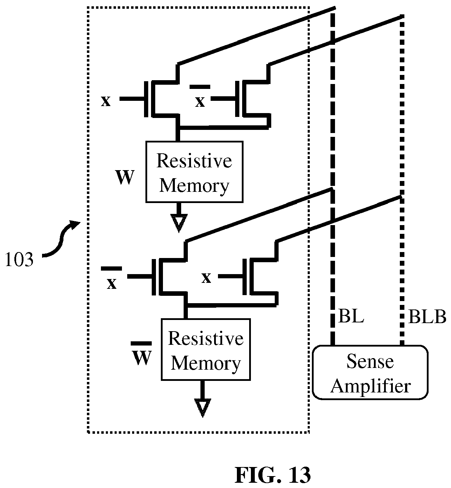

Referring briefly to FIG 13, another variant of an exemplary multiplying memory cell 103 is shown, which can be used in embodiments of the present invention. The memory cell 103 is adapted for storing a binary weight W and its complement Wbar in a respective non-volatile resistive memory element. The resistive memory elements may be switched between a high-resistance state and a low-resistance state to encode and store a binary weight W or its complement. At the same time, the resistance state is determining an amount of current that may be sunken or sourced through the resistive memory element. Depending on the resistance state and on the value taken by the applied activation signal x, or its complement, the predetermined charge state of a first and second read bitline BL, BLB may be changed. For this particular embodiment, the memory cell 103 and the multiplier circuit coincide.

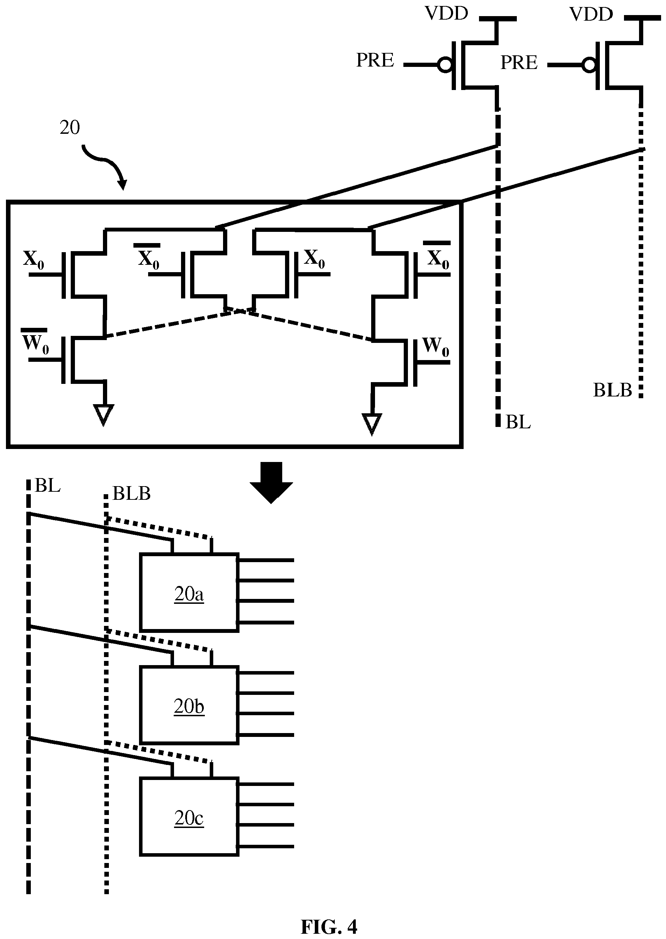

FIG 4 illustrates how six transistors, the gates of which are respectively controlled by the binary activation signal x, its complement xb, the stored binary weight variable and its complement wb, may be arranged to form a multiplier circuit 20 for a memory cell. The action of the multiplier circuit 20 on the connected pair of first and second high-impedance read bitlines BL, BLB is determined by the represented logical value/state of the cell read bit R that is associated with the memory cell. Each read bitline is parallelly coupled to two dynamic AND gates of the multiplier circuit 20, which together act as a dynamic XOR gate for the first read bitline BL and as a dynamic XNOR gate for the second read bitline BLB. FIG. 4 also shows how a plurality of these multiplier circuits 20a-c comprised by a corresponding plurality of memory cells (not shown) are stacked vertically along a same column of a sub-array.

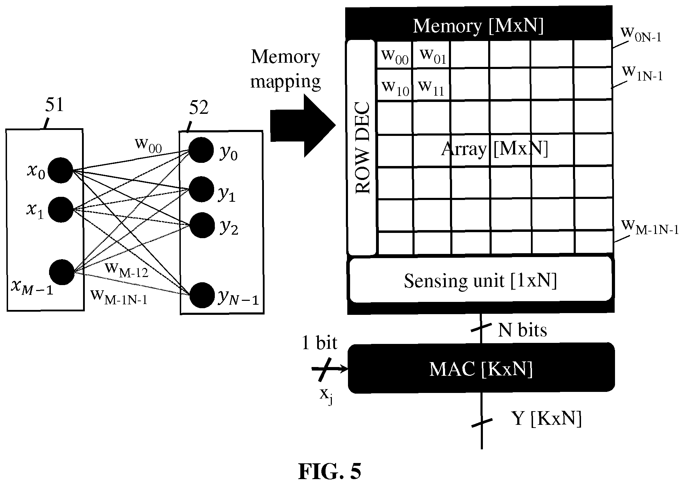

In FIG. 5 a prior art memory mapping is illustrated. In a neural network, e.g. in a multi-layer perceptron or a deep neural network, a first (hidden) layer 51 is receiving a plurality of inputs x₀ to x_{M-1} which are mapped to a plurality of outputs y₀ to y_{N-1}, which are inputs to the next (hidden) layer 52. The plurality of outputs y₀ to y_{N-1} typically are (non-) linear activations of sums of weighted inputs, e.g. ${y}_{i} = f \left({\sum }_{j = 0}^{M - 1} {w}_{ij} {x}_{j}\right) .$ The activation function f operates on an intermediate scalar and does not cause a considerable memory-processor data transfer, but requesting and retrieving the stored weights w multiple times for a single layer to layer mapping of varying input data x in a neural network model does. According to known memory mappings, the network weight w are stored in an MxN array of memory cells, e.g. in an SRAM memory device, wherein weights associated with a single output yⱼ are mapped to the j-th column of the array, meaning that the memory mapping enables column-parallel retrieval of stored weights. A row decoder is configured for writing or reading weights in a row-wise fashion. In order to obtain the N sums of weighted inputs, the row decoder sequentially addressed each one of the M rows of the array the stored weights of which are detected by the sensing unit. The N detected weights stored in a same row are transmitted to an off-memory multiply-and-accumulate MAC unit so that after M read access cycles the N sums of weighted inputs are completed. The MAC unit needs to store the growing intermediate accumulation results. Therefore it includes storage means, e.g. registers, designed to hold a number of KxN bits of information. The MAC unit also accepts one input xⱼ per read cycle, which may be a single bit if the inputs are also binarized, the accepted input being shared between and multiplied with all the detected weights of a same row (the multiply step) and the N products are accumulated with the N partial result stored within the MAC unit (accumulation step). It is noted that in many state-of-the-art neural networks the number of stored weights, e.g. measured by the input layer size M and the output layer size N, is very large, e.g. hundreds of inputs and hundreds of outputs or thousands of inputs and thousands of outputs. Therefore, the known memory mapping requires a large number of cycles to produce the N partial results. Moreover, the storage of intermediate results in the MAC unit, which are based on previously retrieved weights also incurs additional cost in terms of storage capacity and energy spent per read cycle. Also the transfer of detected weights from the memory array to the MAC unit causes delay and energy overhead.

Embodiments of the present invention are aiming at solving these issues by performing to a larger extent the functions that are carried out by the MAC unit directly inside the memory device, e.g. by proposing in-memory processing. The memory cells of the in-memory processing device are arranged in such a way that the high-impedance read bitlines coupled to the cell are charged/discharged according to a cell read bit that represents not the stored weight for retrieval, but a binary product of the stored binary weight variable and a binary activation signal x. Moreover, the in-memory processing device is divided into a number of sub-arrays which simultaneously addressable by multiple binary activation signals at a single read access cycle. The sub-arrays cooperate to form in parallel N digital partial sums during a single read cycle. Hence, the complete N digital sums of weighted inputs are obtained at a reduced number of read cycles.

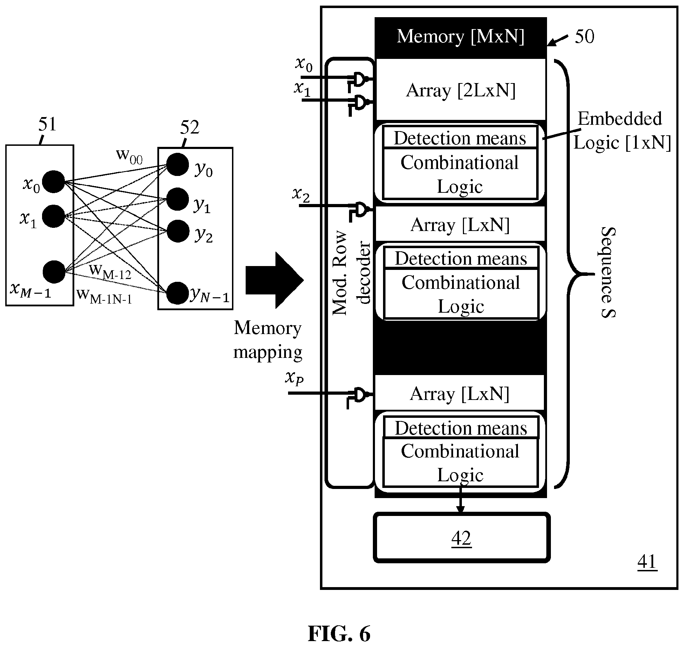

FIG. 6 is illustrating the memory mapping for an embodiment of the invention for the same first layer 51 and second layer 52 of a neural network model as before, e.g. a binary multi-layer perceptron. The in-memory processing device 50 comprises an integer number P of sub-arrays and embedded logic units which are aligned and vertically stacked in an ordered sequence S. Each sub-array comprises N columns and L rows. The first sub-array in the ordered sequence S comprises 2L rows. The sub-arrays form part of a partition of a global memory array of size MxN. The MxN binary weight variable are stored in the global memory array, but are distributed over the P sub-arrays in the sequence S. Here, each one of the outputs yᵢ is still associated with a single column I of the global array, because the individual columns of the sub-arrays are aligned with each other and brought into a logical relationship. The in-memory processing device 50 is forming part of a larger hardware system 41. Such hardware system 41 may also comprise a modified row decoder which allows for P+1 rows of the global array to be simultaneously addressed by P+1 binary activation signals. More specifically, the first sub-array in the sequence S is configured for receiving two binary activation signals x₀ and x₁ at the same time along two of its rows and each further sub-array in the sequence is receiving, also at that same time, a further binary activation signal x₂ to x_{P}. Each embedded logic unit in the sequence S is associated with a sub-array of that sequence, e.g. the adjacent sub-array immediately preceding it in the sequence. The embedded logic units are each of the size 1xN for parallelly processing the N columns of the associated sub-array, wherein parallel processing includes detection of cell read bits in columns of the associated sub-array or detection of relay read bits applied by the preceding embedded logic unit to the read bitlines of the associated sub-array and generating a digital partial sum formed by cell read bits in corresponding columns associated with all the preceding sub-arrays and the associated sub-array in the sequence. The generation of N digital partial sums is achieved by combinational logic inside each embedded logic unit. The hardware system 41 may include a further accumulator unit 42, e.g. a multi-bit adder, which is connected to the combinational logic of the embedded logic unit being last in the ordered sequence S for receiving the N partial sums generated during a single read cycle, e.g. a single clock cycle for a pre-charge signal applied to the in-memory processing device 50. The further accumulator unit 42 is adapted for subsequently adding the N partial sums generated by the connected in-memory processing device 50 over multiple read cycles. It is an advantage of embodiments of the invention that the number of read cycles over which a further accumulator unit accomplishes the full N sums is greatly reduced, e.g. from M read cycles for a conventional memory device of equal total storage capacity MxN to L read cycles, with L = ceil(M/(P+1)) for an embodiment of the present invention.

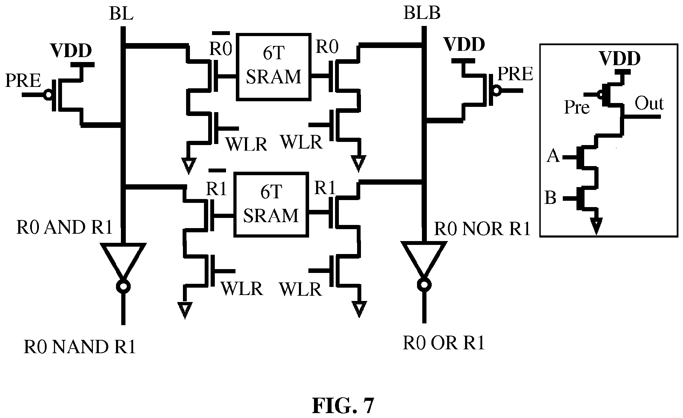

FIG. 7 is illustrating a portion of the first sub-array in the at least one ordered sequence comprised by an in-memory processing device. The shown portion reflects two concurrently addressed memory cells of a same column of the first sub-array in the at least one ordered sequence. Their respective cell read bits are R0 and R1 with respect to the second read bitline BLB of a pair of high-impedance read bitlines connected to the concurrently addressed memory cells, and R0b (for R0bar) and R1b (for R1bar) with respect to the first read bitline BL of the pair of high-impedance read bitlines. For the case in which two memory cells of a same column of a sub-array are addressed, the logical state assigned to the first or the second read bitline BL, BLB, is not solely governed by the cell read bit of a single memory cell, although it is still influencing the assigned final logical state, e.g. the detectable voltage signal after charging/discharging of the individual read bitlines by the multiplier circuits of the two concurrently addressed memory cells. Now, the first read bitline BL is characterized by a logical detectable charge state which depends on the values of the first and the second cell read bits R0 and R1 as BL = R0 AND R1. In contrast, the second read bitline BLB is characterized by a logical detectable charge state which depends on the values of the first and the second cell read bits R0 and R1 as BLB = R0 NOR R1. That means that the logical states characterizing the detectable charge states of the first and second read bitline are defined in terms of Boolean functions having the cell read bits R0 and R1 obtained for a same column of the first sub-array as arguments. Moreover, it is verified that the first and second Boolean function governing the logical detectable charge states of the first and second read bitline, respectively, are such that the dual of the first Boolean function equates to the complement of the second Boolean function, e.g. R0 AND R1 being the first Boolean function and R0 NOR R1 being the second Boolean function.

In the exemplary embodiment in FIG. 7, the detectable charge states may be detected by two inverters connected to the respective ends of the first and second read bitline. Therefore, a detected charge state for the first read bitline is given by the logical expression R0 NAND R1, whereas the detected charge state for the second read bitline is given by the logical expression R0 OR R1. In light of the equations governing the least significant sum bit (e.g. SUM <0>) and the most significant carry bit (e.g. C<0>) in a half-bit adder receiving to binary inputs, e.g. the detected logical charge states for the first and second read bitline, it appears that inverting the detected charge state for the first read bitline again inside the combinational logic of the first embedded logic unit, will generate this most significant (carry) bit of the digital partial sum accumulating the two binary products represented by the cell read bits R0 and R1 in aforementioned column of the first sub-array. Likewise, it can be shown algebraically that the bit-wise NOR operation performed on the detectable (not the detected) logical charge states in respect of the first and second read bitline BL, BLB, precisely generates the least significant (sum) bit of the digital partial sum accumulating the two binary products represented by the cell read bits R0 and R1 in aforementioned column of the first sub-array, e.g. SUM<0> = BL NOR BLB. Therefore, applying the inverted logical states for the first and second read bitline after detection by the inverters, e.g. inverting amplifiers, as inputs to a dynamic AND gate, e.g. the one shown on the right hand side of FIG. 7, will give rise to the least significant (sum) bit, e.g. SUM<0>, of the digital partial sum generated for each column at the level of the first sub-array and associated embedded logic unit.

In some embodiments of the invention, only the carry bits of the generated digital partial sums at the level of the first embedded logic unit are transmitted over dedicated data bitlines to the combinational logic of the subsequent, second embedded logical unit in the at least one ordered sequence. In contrast, the sum bits of the generated digital partial sums at the level of the first embedded logic unit are operatively coupled, e.g. via a plurality of relay switches, to the corresponding pair of first and second high-impedance read bitlines (e.g. BL<1> and BLB<1>) for the corresponding column of the second sub-array in the same ordered sequence. This advantageously reduces the power spent on loading the capacitances related to the data bitlines across the global array.

According to some embodiments of the invention, the same accumulation, i.e. partial sum generation, scheme laid out for the first sub-array in the at least one ordered sequence may be applied by the combinational logic of the second embedded logic unit, except for the minor modification that is taking into account the transmitted carry bit from the first embedded logic unit, that is the most significant (carry) bit, e.g. a1, of the generated digital partial sums at the level of the second embedded logic unit is generated by a dynamic OR gate as a1 = BL<0> OR BL<1> = C<0> OR BL<1>.

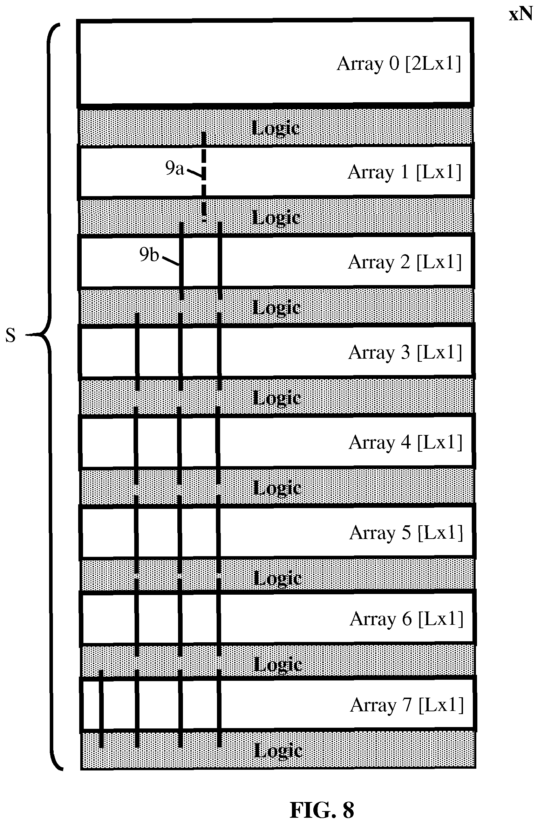

FIG. 8 shows an embodiment of the invention which comprises an ordered sequence of eight sub-arrays (e.g. Array 0 to Array 7) and eight associated embedded logic units (referred to as "Logic" in FIG. 8). In Fig. 8, only a single column is shown for the eight sub-arrays, but in an in-memory processing device according to an embodiment of the invention, such a column is repeated N times. Such embodiment may accumulate up to and including nine binary products into a digital partial sum for each of the N columns of the global array and during a single read cycle. Here, the global array defined by the eight sub-arrays comprises M = 9L rows in total. The first three binary products for each of the N columns are accumulated for the first two sub-arrays of the ordered sequence, "Array 0" and "Array 1", in a way that has been described before. The remaining sub-arrays "Array 2" to "Array 7" each extend the generated digital partial sum for each column by a cell read bit R in that column. The cell read bit R represents another binary product w*x as R = XNOR (w, x). More specifically, the detection means of the embedded logic units associated with each sub-array "Array j" of the remaining sub-arrays "Array 2" to "Array 7" may detect the further cell read bit Rⱼ or its complement Rbⱼ for each of the N columns and the corresponding combinational logic may add the N detected further cell read bit Rⱼ to the N digital partial sums generated so far over the preceding j-1 sub-arrays and associated embedded logic units in the ordered sequence. For instance, the combinational logic of the embedded logic unit associated with the third sub-array "Array 2" may be configured to perform the following compositions of bit-wise defined Boolean operations for each one of the N columns:
- b0 = BLB<2>*NOT(a0) + BL<2>*a0
- b1 = BLB<2>*a0*NOT(a1) + a0*a1 + BL<2>*a1
- b2 = BLB<2>*a0*a1.

Here, the pair of first and second read bitlines for a single column k are designated BL<2>and BLB <2> their detectable charge state is changed according to the complement of the cell read bit Rb₂ or the cell read bit R₂ = XNOR (x₂, w₂ₖ), respectively. The k-th of the N digital partial sums generated by the third embedded logic unit may be denoted PS<2>ₖ = b2 b1 b0 in binary representation with b0 being the least significant bit and b2 being the most significant bit. Likewise, the k-th of the N digital partial sums generated by the second embedded logic unit may be denoted PS<1>ₖ = a1 a0 in binary representation. Again, "+" and "*" respectively represent the bit-wise Boolean operations of "OR" and "AND". The combinational logic of the embedded logic unit associated with the fourth sub-array "Array 3" may be configured to perform the following compositions of bit-wise defined Boolean operations for each one of the N columns:
- c0 =BLB<3>*NOT(b0) + BL<3>* b0
- c1 = BLB<3>*NOT(b2)*NOT(b1)*b0 + NOT(b2)*b1*NOT(b0) + BL<3>*NOT(b2)*b1
- c2 = BLB<3>*NOT(b2)*b1*b0 + b2*NOT(b1)*NOT(b0).

Here, the pair of first and second read bitlines for a single column k are designated BL<3>and BLB <3> their detectable charge state is changed according to the complement of the cell read bit Rb₃ or the cell read bit R₃ = XNOR (x₃, w₃ₖ), respectively. The k-th of the N digital partial sums generated by the fourth embedded logic unit may be denoted PS<3>ₖ = c2 c1 c0 in binary representation with c0 being the least significant bit and c2 being the most significant bit. This pattern may be repeated for the other sub-arrays and associated embedded logic units in the ordered sequence, wherein the pattern is derived from the operation of a full adder for two bits A and B with carry-in bit Cᵢₙ and carry out bit Cₒᵤₜ: $SUM = A ⊕ B ⊕ {C}_{in} ; { C}_{out} = A ⋅ B + {C}_{in} ⋅ \left(A⊕B\right) .$

For this embodiment nineteen additional single bit carrying data bitlines are provided per column for transmitting the number of significant bits from an embedded logic unit to the next one for further accumulation of each of the N digital partial sums. Alternatively, nineteen N-bit wide data bitlines may be implemented. Note that the most significant bit for each of the N digital partial sums generated by the combinational logic associated with the first sub-array "Array 0" is operatively connected to the read bitline of the corresponding column in the second sub-array "Array 1", whereby one data bitline is saved. The number of data bitlines per column for carrying the generated digital partial sum to the next sub-array and associated embedded logic unit in the sequence is increased each time the largest possible number that can be obtained by adding the cell read bits for all the preceding sub-arrays and the current sub-array is requiring a new most significant bit in its binary number representation. Taking a unit capacitance value for a data bitline as the capacitance corresponding to an L rows spanning portion thereof, the present embodiment counts nineteen capacitance units for the data bitlines in each column of the global array.

The binary products represented by the cell read bits may be obtained by the multiplier circuits of the memory cells, e.g. SRAM cells comprising eight, twelve, or fourteen transistors each.

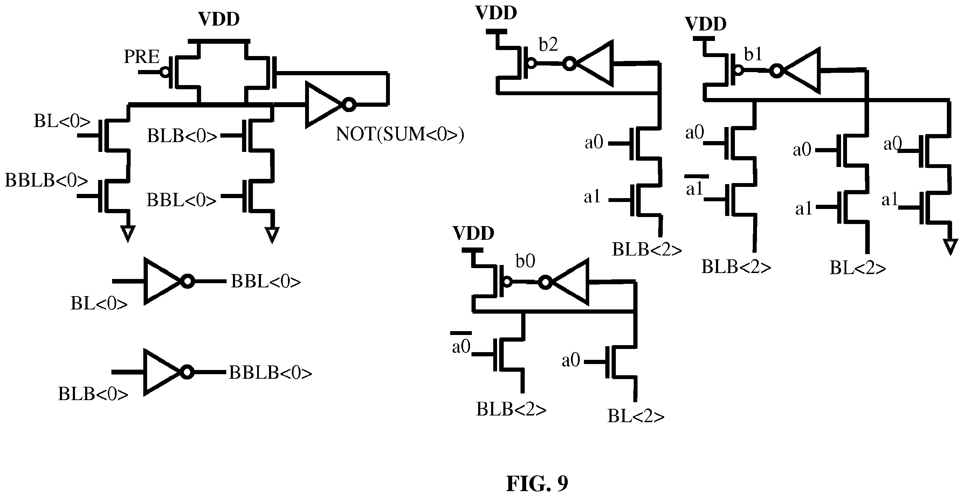

FIG 9 illustrates a circuit schematic for generating the least significant bit, the SUM bit, and its complement, NOT (SUM), on the left hand side. This circuit may be used in the first embedded logic unit for generating the least significant SUM bit as a portion of the digital partial sum generated for each column of the first sub-array in the sequence, comprising the accumulation of two binary products represented by the cell read bits of two concurrently addressed rows in that same column of the associated first sub-array. It is an advantage of this circuit that the complement of the least significant SUM bit is also generated in such a way that its signal level remains at a logical "0" during pre-charging. This avoids the untimely rippling through of generated partial sums in the subsequent embedded logic units in the at least one ordered sequence before the single read cycle has been triggered. The circuit schematic on the right hand sight of FIG. 9 illustrates a way of generating the three significant bits b2, b1 and b0 inside the third combinational logic of the third embedded logic unit in the at least one ordered sequence, which is associated with the third sub-array "Array 2". These three significant bits b2, b1 and b0 completely determine the digital partial sum PS<2> generated by the third embedded logic unit for each of the N columns of the global array. The complements to the three significant bits b2, b1 are also generated before the respective inverters.

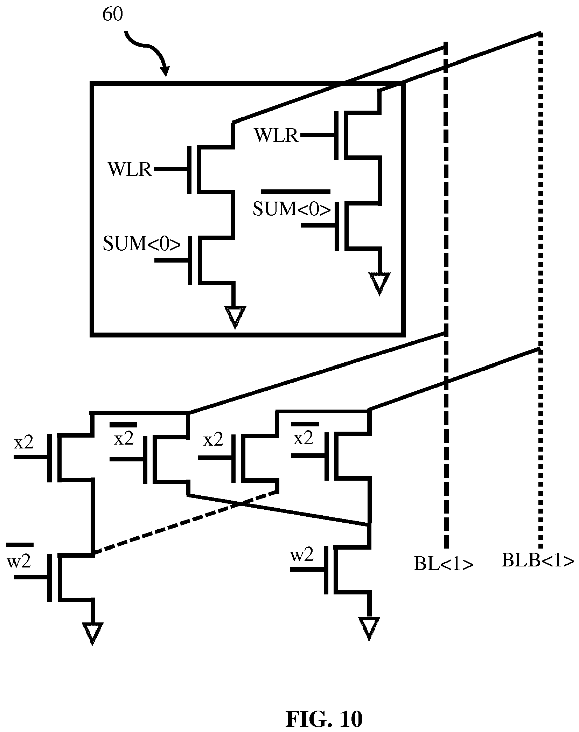

Referring to FIG. 10, an example of a relay circuit 60 for a single column slice is shown, which may be repeated N times, for the N columns of the second sub-array in the at least one ordered sequence to which the N relay circuits are operatively connectable. In the present example, a read wordline WLR may be used provide a read access signal to a plurality of relay switches, e.g. transistors, for operatively connecting the relay read bits to the corresponding paired first and second read bitline of the next sub-array in the at least one ordered sequence. The relay read bits are read bits which are detectable by the detection means of the next embedded logic unit to which the paired first and second read bitlines are connected. Here, the relay read bits correspond to the least significant "SUM" and its complement, which form part of the result of accumulating two binary products in a same column of the first sub-array in the sequence into a digital partial sum at the associated first embedded logic unit. If the relay switches in an on configuration, the relay read bits are coupled to the paired first and second read bitline BL<1> and BLB<1> of a columns of the second sub-array in the ordered sequence. Their action on a predetermined pre-charge state is equivalent to the one of the cell read bit obtained by a multiplier circuit of a memory cell. Therefore it is reasonable to also refer to them as read bits. The relay switches may be used to enable the propagation and rippling through of already generated digital partial sums to the next level in the sequence for further accumulation of binary products. This is indicated in FIG. 10 by the presence of a multiplier circuit for a memory cell which is located in the second sub-array in the at least one ordered sequence.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

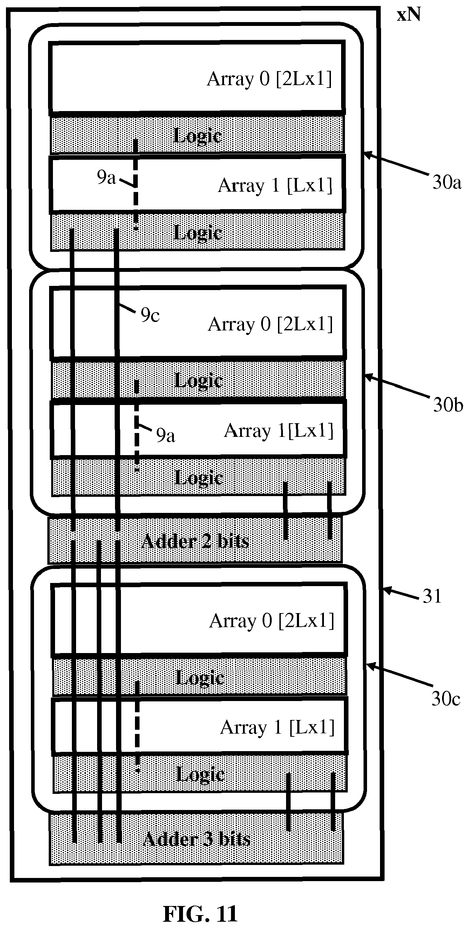

According to another embodiment of the invention, referred to in FIG. 11, an in-memory processing device capable of accumulating up to and including nine binary products into a digital partial sum for each of the N columns of the global array and during a single read cycle may comprise a plurality of ordered sequences of sub-arrays and associated embedded logic units as building blocks 30a-c. Only a single column slice of the embodiment is depicted in FIG. 11 for clarity, but such a column is repeated N times in an in-memory processing device according to the invention. The three building blocks 30a-c are each relating to a different ordered sequence of two sub-arrays and two associated embedded logic units. The global array defined by the sub-arrays of the three ordered sequences comprises M = 9L rows in total. For this particular embodiment plurality of dynamic 2-bit adders and a plurality of dynamic 3-bit adders may also be provided, e.g. one 2-bit adder and one 3-bit adder for each of the N columns of the global array. The 2-bit adders are associated with the second building block 30b and are configured for receiving the two bits wide digital partial sums generated for the sub-arrays of the first building block 30a and the second building block 30b. An output of the 2-bit adders is three bits wide, hence three additional single bit carrying data bitlines are connecting the 2-bit adder in each column to the 3-bit adder in that same column. The 3-bit adders are associated with the third building block 30c and are configured for receiving the two bits wide digital partial sums generated for the sub-arrays of the third building block 30c and the three bits wide digital partial sums connected 2-bit adders. An output of the 3-bit adders constitutes the N digital partial sums accumulated over the three building blocks 30a-c and each digital partial sum therein is comprising nine binary products.

Taking a unit capacitance value for a data bitline as the capacitance corresponding to an L rows spanning portion thereof, the present embodiment counts eighteen capacitance units for the data bitlines in each column of the global array.

In an extension of this embodiment, the three building blocks and the plurality of 2-bit and 3-bit adders form part of a higher hierarchical building block 31. Similarly to the stacking of building blocks 30a-c, three or more higher hierarchical building blocks 31 may be stacked together for obtaining an in-memory processing device capable of accumulating up to and including at least twenty-seven binary products into a digital partial sum for each of the N columns of the global array. If three higher hierarchical building blocks 31 are stacked into a larger in-memory processing device, a first plurality of dynamical 4-bit adders associated with the second higher hierarchical building block 31 may be provided for generating the N digital partial sums for the two first higher hierarchical building blocks 31 in the stack on the one hand and, on the other hand, a second plurality of dynamical 4-bit adders associated with the third higher hierarchical building block 31 may be provided for generating the N digital partial sums for the third higher hierarchical building block 31 in the stack and for summing thereto each of the N digital partial sums generated by the first plurality of dynamical 4-bit adders. An output for such extension then corresponds to N digital partial sums generated for the three higher hierarchical building blocks 31 and each digital partial sum therein is comprising twenty-seven binary products. This is of particular interest in convolutional binary neural network applications for which typical filter sizes are 3x3 or 5x5.

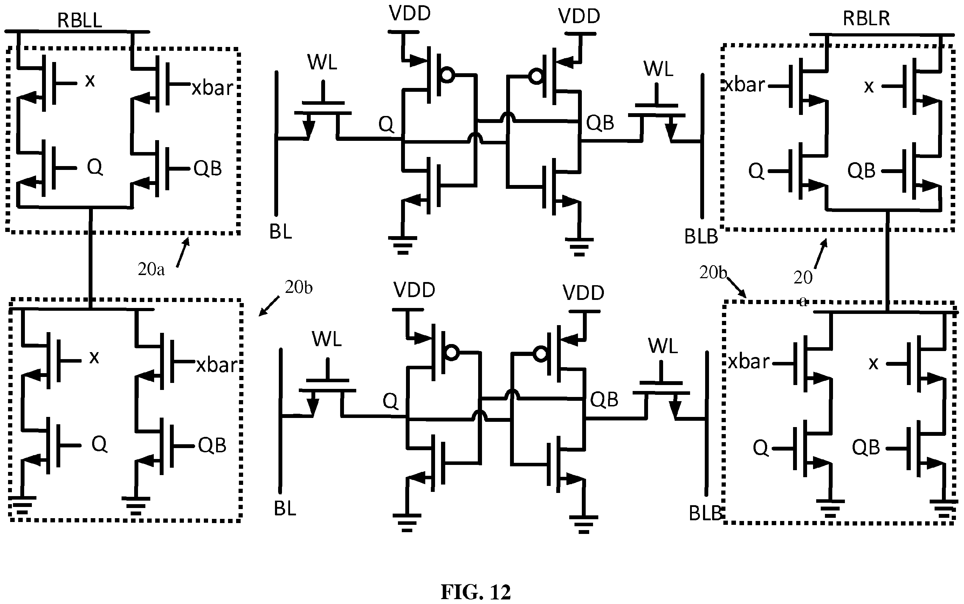

According to same or other embodiment of the invention, an in-memory processing device may comprise, for at least one sub-array therein, memory cells which are provided as SRAM cells, each having fourteen transistors. Referring to FIG. 12, two such fourteen-transistor SRAM memory cells are shown, which are belonging to a same column of the at least one sub-array. The two SRAM memory cells are stacked onto each other and form a pair of stacked SRAM cells. As shown in FIG. 12, only the first, upper one of the two stacked SRAM cells has its multiplier circuit 20a directly connected to the paired first and second read bitline RBLL, RBLR of the corresponding column. In contrast, the second, lower one of the two stacked SRAM cells has its multiplier circuit 20b indirectly connected to the paired first and second read bitline RBLL, RBLR via the multiplier circuit 20a of the first one of the two stacked SRAM cells. Hence, the two stacked SRAM cells hooked up in series are both together determining how a pre-charge state of the coupled first and second read bitlines is changed depending on the cell read bit for the first and the cell rad bit for the second SRAM memory cell. This embodiment is useful for further reducing the switching activity on the read bitlines themselves, because the two multiplier circuits 20a, 20b are connected in such a way that the corresponding cell read bits R1 and R2 both determine the detectable charge state for the first and second read bitline as NAND(R1, R2) and OR(R1, R2), respectively. This also provides a set of first and second Boolean function of two arguments R1 and R2, for which the dual of the first Boolean function is equal to the complement of the second Boolean function. This is an alternative to bitwise operations on the first and second read bitlines given by Boolean NOR and AND functions. This alternative is preferred since Boolean OR and NAND functions involve three times less transitions, which cause switching on the read bitlines (full swing) or for the connected detection means (converting small swing into full swing). For this particular embodiment, inverters as detection means connected to the read bitline pairs may be substituted by non-inverting sense amplifiers, which offer the advantage of detecting non-full swings for voltage drops on the read bitlines in a more energy-efficient manner.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. An in-memory processing device (1) for parallelly computing N digital partial sums in a binary neural network during a read cycle, comprising at least one ordered sequence (S) of P sub-arrays (3a, 3b) and of P embedded logic units (4a, 4b), with P being an integer number greater than one, each sub-array (3a, 3b) being associated with a respective one of the embedded logic units (4a, 4b),
each sub-array (3a, 3b) comprising:
▪ a plurality of memory cells (10) arranged in rows and N columns, wherein
each column (Aa-Ea) of one of the sub-arrays (3a) corresponds to a column (Ab-Eb) of every other sub-array (3b), thus defining a partition of a global array into the sub-arrays (3a, 3b) of each ordered sequence, and
individual rows of memory cells (10) are concurrently addressable by one of a plurality of binary activation signals (x), and
each memory cell (10) is adapted for storing a binary weight variable (w) and is comprising a multiplier circuit adapted for changing, according to a cell read bit or the complement thereof, a pre-charge state of each read bitline coupled to the memory cell, said cell read bit representing a binary product of the stored weight variable (w) and an applied activation signal (x),
▪ a plurality of activation bitlines (7), each being coupled to the memory cells (10) of a same row, for receiving the plurality of binary activation signal (x),
▪ a plurality of paired first and a second high-impedance read bitlines (8, 8'), each paired first and second read bitline being coupled to the memory cells (10) of a same column, and
each embedded logic unit (4a, 4b) comprising:
▪ detection means (6) connected to the read bitlines of the associated sub-array (3a, 3b) for detecting a charge state for each connected read bitline,
▪ a combinational logic (5a, 5b) for generating N partial digital sums during the read cycle, based on the detected charge states for the associated sub-array (3a, 3b) and on the N partial digital sums generated for a combinational logic (5a) preceding the combinational logic (5b) in the same ordered sequence (S), wherein
each of the N partial digital sums generated by a combinational logic (5a, 5b) is accumulated from cell read bits with respect to concurrently addressed memory cells (10) in a same column (Aa-Ea, Ab-Eb) of the associated sub-array (3a, 3b) and from cell read bits with respect to further concurrently addressed memory cells (10) in the corresponding columns (Aa-Ea) of all sub-arrays (3a) preceding the associated sub-array (3b) in the same ordered sequence (S), there being two cell read bits with respect to two concurrently addressed memory cells (10) in each column (Aa-Ea) of the sub-array (3a) being first in each ordered sequence (S).

2. An in-memory processing device according to claim 1, wherein the embedded logic unit (4a) being first in each ordered sequence (S) further comprises N relay circuits (60), each relay circuit being
operatively connectable to the corresponding paired first and second read bitline of the next sub-array (3b) in that ordered sequence (S), and
adapted for changing a pre-charge state for each of the operatively coupled read bitlines of the next sub-array (3b) in that ordered sequence (S), according to a relay read bit and the complement thereof, each relay read bit corresponding to a least significant bit (LSB) of one of the N partial digital sums generated by the combinational logic (5a) of the embedded logic unit (4a).

3. An in-memory processing device according to claim 1 or 2, further comprising a plurality of data bitlines (9, 9a-b) connecting each embedded logic unit (4a) of the at least one ordered sequence (S) to the next embedded logic unit (4b) of that ordered sequence (S), the plurality of data bitlines being configured for transmitting at least a most significant bit (MSB) for each of the generated N digital partial sums.

4. An in-memory processing device according to claim 3, wherein P is an integer number greater than two for the at least one ordered sequence (S) and wherein the plurality of data bitlines (9b) are configured for transmitting all significant bits for each of the N digital partial sums generated by the combinational logic of the second and of any further embedded logic unit in the at least one ordered sequence (S).

5. An in-memory processing device according to any of the previous claims, wherein detectable charge states for paired first and second read bitlines are respectively indicative of a first Boolean function and a second Boolean function, both first and second Boolean functions having one read bit in a column (Aa-Ea, Ab-Eb) of the associated sub-array (3a,3b) as argument or both first and second Boolean function having two read bits in a same column (Aa-Ea, Ab-Eb) of the associated sub-array (3a,3b) as arguments.

6. An in-memory processing device according to claim 5, wherein, for at least two consecutive embedded logic units (4a, 4b) of the at least one ordered sequence (S), both first and second Boolean function are having two read bits in a same column (Aa-Ea, Ab-Eb) of the associated sub-array (3a,3b) as arguments, and wherein the dual of said first Boolean function is equating to the complement of said second Boolean function.

7. An in-memory processing device according to any of the previous claims, wherein the combinational logic (5a, 5b) for each embedded logic unit comprises dynamic OR gates, dynamic NAND gates, or a combination of dynamic OR gates and dynamic NAND gates, individual dynamic gates being arranged for receiving detected charge states for a paired first and second read bitline as input signals.

8. An in-memory processing device according to any of the previous claims, wherein the multiplier circuit of a memory cell (10) comprises a dynamic XNOR gate and a dynamic XOR gate.

9. An in-memory processing device according to any of the previous claims, comprising a plurality of ordered sequences of P_{K} sub-arrays and of P_{K} embedded logic units each, each P_{K} being an integer number greater than one, and at least one dynamic adder for generating N digital partial sums by further accumulating the partial digital sums generated by the combinational logics of the embedded logic units being last in each individual ordered sequence.

10. An in-memory processing device according to any of the previous claims, wherein the embedded logic units are also adapted for generating the complement of said generated N digital partial sums.

11. An in-memory processing device according to claim 10, wherein the complement of said generated N digital partial sums is generated in such a way that a representative signal level thereof corresponds to a logical zero during a pre-charging phase of the read bitlines.

12. An in-memory processing device according to any of the previous claims, wherein the memory cells (10) of at least one sub-array are provided as SRAM cells, each comprising fourteen transistors, and wherein at least one pair of two stacked SRAM cells is provided for each column such that a first one of the two stacked SRAM cells of the at least one pair is directly connected to the read bitlines of that column and the second one of the two stacked SRAM cells of the at least one pair is coupled to the read bitlines of that column only via the first of the two stacked SRAM cells of the at least one pair.

13. A hardware system (40, 41) for computing N digital partial sums in parallel in a binary neural network, comprising an in-memory processing device (1, 50) according to any of the previous claims and a row decoder (2) configured for simultaneously applying multiple binary activation signals (x) to multiple activation bitlines (7) of concurrently addressed rows at the start of a read cycle.

14. A hardware system (41) according to claim 13, further comprising a multi-bit adder (42) connected to the in-memory processing device (50), the multi-bit adder being adapted for further accumulating, over a plurality of read cycles, the N digital partial sums obtained by the in-memory processing device for each read cycle in the plurality of read cycles.
